# EUROPEAN PATENT APPLICATION

(11) **EP 3 499 824 A1**
(43) Date of publication of application: **19.06.2019**
(21) Application number: 18852708.9
(22) Date of filing: 29.03.2018
(51) Int. Cl.: H04L 27/02

(54) **HIGH-SPEED COMMUNICATION METHOD AND HIGH-SPEED COMMUNICATION SYSTEM**

(30) Priority: 10.09.2017 JP 2017173603
(71) Applicant: Fukui, Seiji, Yokohama-shi, Kanagawa 230-0015 (JP)
(72) Inventor: Fukui, Seiji, Yokohama-shi, Kanagawa 230-0015 (JP)
(74) Representative: Gill, David Alan
(86) International application number: PCT/JP2018/015631
(87) International publication number: WO 2019/049413

(57) **Abstract**

There is provided a high-speed tele-communication method and a high-speed tele-communication system which can be easily realized with a simple configuration, with good operability, at low cost, and in a short term without considerably improving or substituting existing communication-related equipment by improving the foregoing problems of technologies in the related art.

A high-speed tele-communication method high-speed tele-communication system 100 causes a waveform within a unit period time in an analog waveform signal of a carrier wave or basic frequency wave 400 to respond to a digital signal 300 of information BD to be transmitted and deform the waveform.

## Description

### Technical Field

The present invention relates to a high-speed tele-communication method and a high-speed tele-communication system, and more particularly, to a high-speed tele-communication method and a high-speed tele-communication system capable of performing high-speed tele-communication with no new equipment and excellent in operability and economy at low cost because of a simple configuration without expecting further improvement in a precise, complicated, and expensive data processing device or transmission device.

### Background Art

In the related art, operations of transmitting and receiving various kinds of information easily and freely have been performed frequently irrespective of wired and wireless ways. With development and advance in tele-communication technologies, opportunities to transmit and receive the various kinds and large amounts of information frequently have expanded and its importance will increase in future.

In particular, in recent years, due to expansion and progress of economic activities, an improvement in economic power of individual users, an increase in desires for individual consumption, and further, for example, due to practical application of high-quality televisions or smartphones and high frequent operation in financial and investment transactions , or due to practical application of two-way competing games or the like, it has been demanded that the information communication should have higher speed, larger amounts, and further elaboration thereof. Thus, development of technologies necessary for these are inevitably requested and development of corresponding necessary technologies are eagerly in progress under keen competitions.

For example, for the number of bits transmitted per second (bit/sec) considered to achieve high speed, at present, practical application of a high communication speed from several Gbit/sec to 60 Gbit/sec beyond Mbit/sec has been achieved. In very near future, the high communication speed is expected to reach up to a state in which a waveband zone called a so-called terra level is used.

Additionally, to accelerate a communication speed, there is necessity of development of communication software and simultaneously, in terms of hardware, except for a method of improving a transmission speed (frequency), there exists several ideas which being considered to be utilized, for example, technologies for widening a signal bandwidth, improving an SN ratio, using a parallel transmission circuit in which a plurality of transmission circuits, or the like. However, since in each one of these ideas, a considerable time and cost are necessary with development of equipment devices, the systems are not expected to have effects immediately despite practical applicability. Further, even when the systems are realized, there is the disadvantage of high cost.

Additionally, for the high-speed tele-communication, as described above, a considerable improvement in the transmission speed is achieved compared to the previous communication. However, for example, when a catastrophe such as earthquake occurs, a communication amount between users temporarily increases. Thus, since communication capabilities may malfunction and thus the communication is shut down, a fundamental problem that required calls may not be performed at required times has not yet been solved in some aspects.

That is, in current high-speed tele-communication systems, communication of police, the self-defense forces, fire-fighting, administrative organizations, and the like have priority nominally in the catastrophe. Thus, there is a fatal defect that ordinary people are alienated from the communication.

Accordingly, in recent years, it is desirable to realize a high-speed tele-communication system which can be easily realized with a simple configuration, with good operability, at low cost, and in a short term without considerably improving or substituting existing communication-related equipment.

### Citation List

### Patent Literature

Patent Literature 1: JP 62-295539 A
Patent Literature 2: JP 63-131705 A
Patent Literature 3: JP 5-83032 A
Patent Literature 4: JP 2015-115771 A
Patent Literature 5: JP 2014-068069 A
Patent Literature 6: JP 2010-200071 A
Patent Literature 7: JP 2008-271148 A
Patent Literature 8: JP 2002-185610 A

### Summary of Invention

### Technical Problem

Accordingly, an object of the present invention is to provide a high-speed tele-communication method and a high-speed tele-communication system which can be easily realized with a simple configuration, with good operability, at low cost, and in a short term without considerably improving or substituting existing tele-communication-related equipment by improving the foregoing problems of the technologies in the related art.

### Solution to Problem

According to the present invention, technical configurations to be described below are adopted basically to solve the foregoing problems of the technologies in the related art and achieve the foregoing object of the present invention.

That is, according to a first aspect of the present invention, there is provided a high-speed tele-communication method which being characterized by deforming a waveform within a unit period of time in an analog waveform signal of a carrier wave or basic frequency wave in response to a digital signal of information to be transmitted.

Further, according to a second aspect of the present invention, in association with the first aspect of the present invention, there is provided a high-speed tele-communication system which comprising, at least, an input means for carrier wave or basic frequency wave, an analog signal waveform deformation processing means for the carrier wave or basic frequency wave, a process operating signal generation means for operating the analog signal waveform deformation processing means for the carrier wave or basic frequency wave, and digital signal input means for information to be transmitted, wherein the process operating signal generation means outputs an operating and processing signal in response to a digital signal of the information to be transmitted, which is input to the digital signal input means.

### Advantageous Effects of Invention

According to the present invention, each one of the present inventions has the above-mentioned technical construction, a high-speed tele-communication method and a high-speed tele-communication system which can be easily realized with a simple configuration, with good operability, at low cost, and in a short term without considerably improving or substituting existing tele-communication-related equipment by improving the foregoing problems of the technologies in the related art, can be easily provided.

Further, according to the high-speed tele-communication method provided by the present invention, it is possible to solve the foregoing problems of the related art and to realize the high-speed tele-communication method within the range of a transmission speed of 1 to 60 Gbit/sec, which being sufficiently and successfully used until now, without using a frequency of a terra wavelength band.

### Brief Description of Drawings

Fig. 1 is a block diagram illustrating an example of a configuration of a specific example in a first aspect of a high-speed tele-communication method according to the present invention.
Fig. 2 is a block diagram illustrating an example of a configuration of a specific example of a high-speed tele-communication system in a second aspect according to the present invention.
Fig. 3 is a diagram illustrating an example of a deformed waveform state of the carrier wave when a carrier wave within a unit period of time is divided into 4 pieces and is deformed in the high-speed tele-communication method according to the present invention.
Fig. 4 is a diagram illustrating a specific example of a process of comparing the carrier wave subj ected to the waveform deformation illustrated in Fig. 3 with a predetermined threshold so as to digitize the carrier wave.
Fig. 5 is an exemplary diagram illustrating a part of an example of a deformed waveform state when the carrier wave within the unit period of time is divided into 8 pieces and is deformed in the high-speed tele-communication method according to the present invention.
Fig. 6 is a diagram illustrating a specific structure of a configuration example of a switching means used in the high-speed tele-communication method according to the present invention.
Fig. 7 is a diagram illustrating a specific structure of another configuration example of the switching means used in the high-speed tele-communication method according to the present invention.
Fig. 8 is a block diagram illustrating an example of still another specific example of configuration in the high-speed tele-communication method according to the present invention.

### Description of Embodiments

Hereinafter, a configuration example in each specific example of a high-speed tele-communication method and a high-speed tele-communication system according to the present invention will be described with reference to the drawings.

First, an example of a specific configuration of the high-speed tele-communication method according to a first aspect of the present invention will be described.

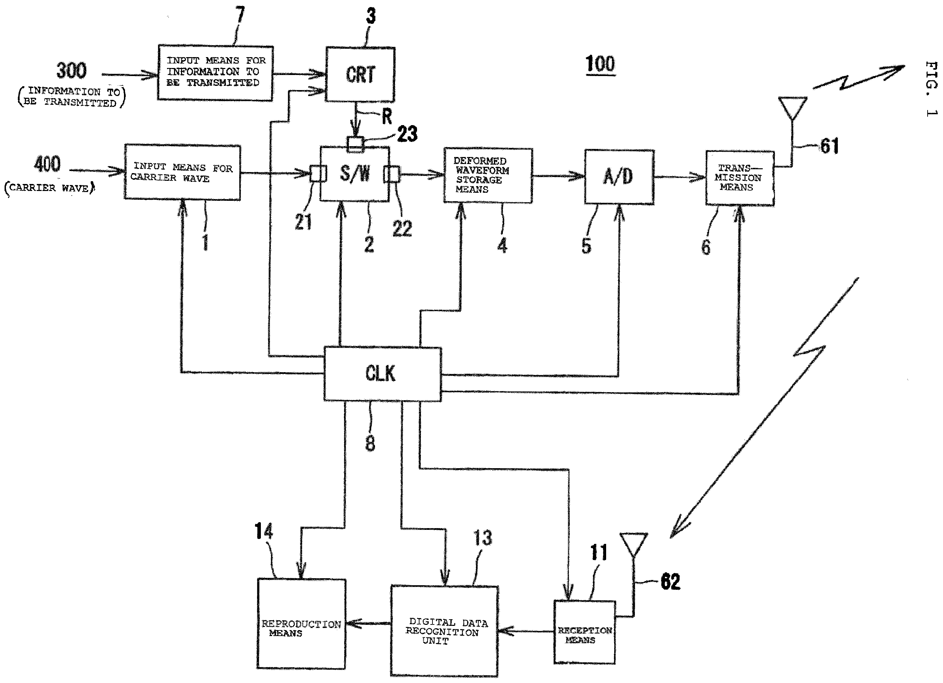

That is, Fig. 1 illustrates a configuration of a specific example of a high-speed tele-communication method 100 according to a first aspect of the invention. The drawing illustrates the high-speed tele-communication method 100 in which a waveform of an analog waveform signal of a carrier wave or an analog waveform signal of a basic frequency wave 400 within a unit period of time to is deformed in response to a digital signal 300 of information BD to be transmitted.

Note that, a basic technical conception of the present invention is substantially different from the conventional trend of making a current tele-communication speed mote higher, such as for example, focusing on an improvement or a development of various kinds of relevant hardware or development and a development of relevant software, each of which being a development requiring considerable cost and a long time and thus the basic technical conception of the present invention is a high-speed tele-communication method or a high-speed tele-communication system 100 based on a novel technical conception in which a waveform signal of a currently used carrier wave or a currently used basic frequency wave is firstly deformed with a predetermined deforming process causing a predetermined deformation on such waveform, and successibly new digital signals are generated, and thereby considerably increasing the number of digital information to be included in the currently used normal carrier wave or the currently used normal basic frequency wave which can enable to increase the number of pieces of digital information included in the carrier waveform or basic frequency wave, which being currently transmitted with in a currently generally used data transmission speed so that a considerable improvement on the data transmission speed can be realized.

It is needless to say that the carrier wave or basic frequency wave 400 used in the present invention may have a vibration wave that has a frequency and a certain amplitude to the degree that the vibration wave is used for general information communication and, in particular, the basic frequency wave 400 may be output by a known crystal oscillator or the like, without necessity to be limited to specific characteristics.

The frequency of the carrier wave or basic frequency wave 400 used in the present invention is also not particularly limited to a specific number of the frequency. As described above, in consideration of practical use, an example in which the frequency is set at about 60 Gbit/sec as an upper limit is a desirable specific example.

On the other hand, as a constituent element, the waveform of an analog waveform signal of the carrier wave 400 used in the high-speed tele-communication method within a unit period of time TU (one waveform) is deformed by responding to the digital signal 300 of the information (BD) to be transmitted. However, in the analog waveform signal of the carrier wave or basic frequency wave 400, a waveform within the unit period of time TU (one wavelength) means a basic waveform expressed within a time of one period (Hz) in an analog signal of the carrier wave or basic frequency wave 400. When one period is 1 second, 1 second which is a time of 1 Hz is the unit period of time TU. When one period is 100 Hz, 1/100 seconds is the unit period of time TU.

An analog waveform in a case in which travel of 360 degrees once within the unit period of time TU is performed is considered.

As a specific example, it is needless to say that a waveform of one period of the carrier wave or basic frequency wave with a frequency of 1 KHz, 10 MHz, or the like is a target.

Further, in the present invention, as a specific example in which the waveform of the carrier wave or basic frequency wave to be input is deformed, for example, an operation is appropriately performed in such a manner that an appropriate switching means 2 or an analog signal waveform deformation processing means 2 is used to output the waveform of the input carrier wave or basic frequency wave 400 to a desired output side when a control signal input to the switching means 2 or the analog signal waveform deformation processing operation means 2 is 0 or 1; and the waveform of the input carrier wave or basic frequency wave 400 is not output to a desired output side when the control signal input to the switching means 2 or the analog signal waveform deformation processing operation means 2 is 1 or 0.

The configuration of the analog signal waveform deformation processing operation means 2 used in the present invention is not particularly limited. A device or a member included in a known switching circuit of the related art can be used. In addition, as one specific example of the present invention, control means 3 for supplying a desired control signal R and controlling a processing operation of the analog signal waveform deformation processing operation means 2 is connected to a switching circuit 23 included in the analog signal waveform deformation processing operation means 2 or separately installed into the analog signal waveform deformation processing operation means 2.

More specifically, when the appropriate control signal R output from the control means 3 is input to the switching circuit 23, the waveform of the waveform 400 of the carrier wave or the basic frequency wave input to the appropriate input unit 21 of the analog signal waveform deformation processing operation means 2 is selectively output from the appropriate output unit 22 of the analog signal waveform de formation processing operation means 2 as a deformed wave form 410 to the desired output side in response to a kind of signal R input from the control means 3. In short, a switching operation performed whether or not the waveform 400 of the carrier wave or the basic frequency wave input to the analog signal waveform deformation processing operation means 2 is output to the output unit 22 which is an output side of the analog signal waveform deformation processing operation means 2 within each unit time TU can be performed.

When a waveform 410 obtained by applying a desired waveform deformation to the waveform 400 of the carrier wave or basic frequency wave can be output from the output unit 22, any kind of switching means 23 having the function of outputting the deformed waveform to the output unit 22 can also be used in the analog signal waveform deformation processing operation means 2.

In the present invention, it is needless to say that the switching circuit 23 and the control means 3 may be integrated.

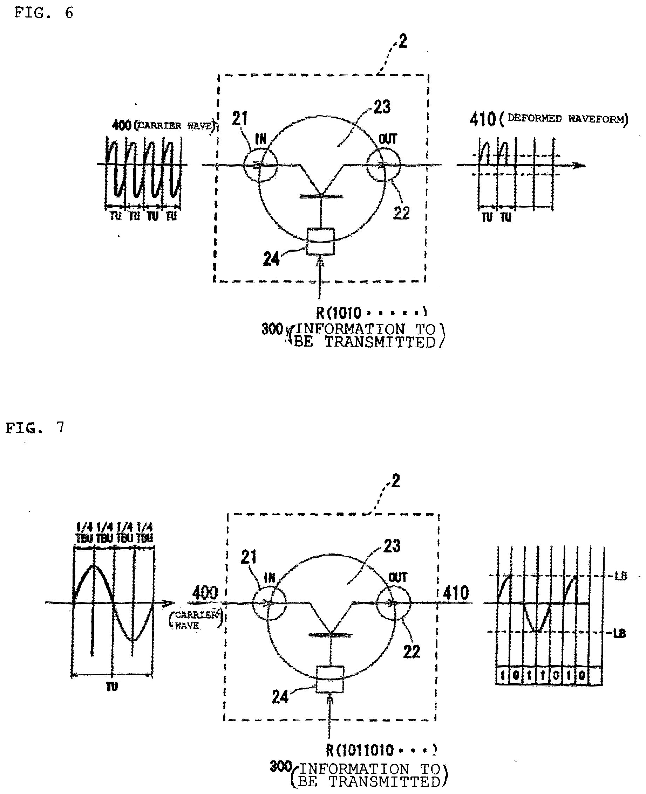

Specifically, the analog signal waveform deformation processing means 2 in which a semiconductor switching circuit 23 illustrated in Fig. 6 is used, can also be used.

That is, the semiconductor switching circuit 23 has a switching circuit that includes an input unit 21 to which the carrier wave or basic frequency wave 400 is input, an output unit 22 that outputs a processed waveform, and a control signal input unit 24 to which the appropriate control signal R output from the control means 3 is input at a predetermined timing.

Here, it is needless to say that the control signal input unit 24 illustrated in Figs. 6 and 7 has the same function as process operating signal generation means or control signal generation means 3 in Fig. 1.

As the control signal input unit 24 of the analog signal waveform deformation processing operation means 2 in the present invention, a contactless signal input means in which, for example, optical coupling or the like is used, canal so be used, and thereby, it is possible to reduce a part of noise.

In the high-speed tele-communication method 100 according to the present invention, digital data BD included in the desired information 300 to be transmitted is used as the control signal R input from the control means 3 to the switching means 23 in the analog signal waveform deformation processing operation means 2.

Here, a specific example of a basic configuration of the high-speed tele-communication method 100 according to the present invention described above will be described with reference to the block diagram illustrated in Fig. 1.

Note that, as illustrated in Fig. 1,as a desirable specific example of a configuration for realizing an operation of the high-speed tele-communication method 100 according to the present invention, comprises an input means 1 to which an analog waveform signal of the desired carrier wave or basic frequency wave 400 is input, the analog signal waveform deformation processing operation means 2 that is connected to the input means 1 and includes therein the foregoing switching means 23, deformed and processed waveform storage means 4 that is connected to an output unit 22 of the analog signal waveform deformation processing means 2 and stores a deformed and processed waveform 410, an analog-digital conversion means 5 for comparing the deformed and processed waveform 410 with a desired threshold LB to generate digital information, a transmission means 6 for transmitting the digital data output from the analog-digital conversion means 5 to a spatial area through appropriate antenna means 61, a control signal input means 7 for inputting basic digital data BD obtained by digitizing the information 300 to be transmitted through appropriate analog-digital conversion means (not illustrated), and a processed and operated signal generation means 3 functioning as control means that is connected to a basic digital data BD input unit 31 receiving signal information output from the control signal input means 7 and the switching means 23 of the analog signal waveform deformation processing operation means 2 and supplies the appropriate control signal R to the switching means 23.

That is, as one specific example in the high-speed tele-communication method 100 according to the invention, it is characterized in that an input analog signal waveform is deformed by the analog signal waveform deformation processing operation means 2 for the carrier wave or the basic frequency in response to the digital signal 300 of information to be transmitted.

In the foregoing specific example according to the present invention, it is needless to say that the deformed and processed waveform storage means 4 may not be provided or may be simple buffer means.

On the other hand, according to a second aspect of the present invention, the high-speed tele-communication system 100 is characterized by that it is provided with at least the input means 1 for the carrier wave or basic frequency wave 400, the analog signal waveform deformation processing operation means 2 for the carrier wave or the basic frequency wave, the processed and operated signal generation means 3 that is control means for operating and controlling the analog signal waveform deformation processing operation means 2 for the carrier wave or basic frequency wave 400, and a digital signal input means 7 that is connected to the processed and operated signal generation means 3 and serving as an input means for the information 300 to be transmitted, and wherein, the analog signal waveform deformation processing operation means 2 is configured to perform an analog signal waveform deformation processing operation in accordance with a characteristic value of an operation processing signal R in response to a digital signal of the information 300 to be transmitted, the digital signal being output from the process operating signal generation means 3 and input to the digital signal input means 7.

As a desirable specific example of the high-speed tele-communication method 100 according to the present invention, as illustrated in Fig. 1, at least the input means 1 for the carrier wave or basic frequency, the analog signal waveform deformation processing means 2, the deformed and processed waveform storage means 4, the analog-digital conversion means 5, and the control means 3 are synchronized and driven through same reference clock means 8.

In the high-speed tele-communication method 100 according to the present invention, the digital data BD that has desired information 300 to be transmitted is used as the control signal R input to the switching means 23 being provided in the analog signal waveform deformation processing means 2, from the control means 3,.

In the foregoing specific example according to the present invention, when an appropriate waveform deformation process is simply performed within the unit period (one wavelength) time (Hz) of a desired carrier signal or the basic frequency wave 400, digital information included within the unit period time of the carrier signal or the basic frequency wave 400 does not increase in some cases depending on a specific example.

That is, in general, four kinds of 2-bit digital data can be stored in a waveform within the unit period of time of the carrier wave.

Accordingly, even when the foregoing deformation process is performed at every 180 degrees within the unit period of time at the time of performing the waveform deformation process, the deformed waveform 410 can simply store same four kinds of 2-bit digital data therein only but it is currently difficult to store in the deformed waveform 410, much more number of pieces of data than that the same four kinds of 2-bit digital data and which the original wave form 400 can store therein, which being currently stored in the current deformed waveform 410.

Therefore, in the present invention, as a second specific example, an analog signal waveform within the unit period of time (Hz·TU) in the carrier wave or basic frequency wave 400, that is, an analog signal wave in one wavelength, is divided into N pieces along a time axis, an appropriate control signal is output for each 1/N time of the one individual wavelength time in sequence along the time axis, and a waveform deformation process is performed through the foregoing appropriate switching means 2.

That is, in the present invention, as the second specific example, in the high-speed tele-communication method 100, a process is performed such that a waveform of the carrier wave of an output side is deformed by dividing an analog signal waveform within the unit period (one wavelength) of time in the carrier wave or basic frequency wave 400 into N pieces along the time axis, inputting the digital data information BD regarding the information 300 to be transmitted as the control signal R for each 1/N time of the one individual wavelength time in sequence along the time axis to the switching means 23 of the analog signal waveform deformation processing operation means 2 through the control means 3 at a predetermined timing, driving the analog signal waveform deformation processing operation means 2, and performing a selection operation of selecting whether to output the analog signal waveform in the carrier wave or basic frequency wave 400 within the 1/Nperiod to the output side (a making process) or not (a breaking process).

In this specific example, the division number N is not particularly limited, but any division number such as 4 divisions, 8 divisions, 16 divisions, or 32 divisions can be optionally selected. Therefore, as a general expression, the division number N to be selected is expressed as N = 2^{x}. Here, x is one integer selected from 2 and an integer equal to or greater than 2.

That is, in a digital data process of the related art, whenever an analog signal waveform within the basic unit period of time progress at 180 degrees along the time axis, the analog waveform is compared to a desired threshold set appropriately and digital information of "0" or "1" is determined. As a result, in the related art, only four kinds of 2-bit digital information can be obtained within the basic unit period (one wavelength), for example, in a 1 Hz state in which one period is set for 1 second. In the present invention, however, the basic unit period (one wavelength) of time (TU) is divided into, for example, 4 pieces and the control signal R formed by digital data of the information 300 to be transmitted is input to the switching circuit 23 of the analog signal waveform deformation processing operation means 2 in sequence via the control means 3 for each divided 1/4 basic unit period of time (TBU). Thus, in response to digital data characteristics (that is, one of 0 and 1) of the input information 300 to be transmitted, an operation of transmitting or not transmitting the analog signal waveform 400 input within each 1/4 basic unit period time TBU to the deformed and processed waveform storage means 4 is performed and the deformed waveform 410 is output from the analog signal waveform deformation processing operation means 2.

In the foregoing specific example, even when the division number N is 8, 16, or a larger number, a similar operation is performed.

The overview of the operation in the configuration of the specific example is exemplified in Fig. 7. For example, when the digital data of the input information 400 to be transmitted is 1, the waveform of the analog signal 400 input within the 1/4 basic unit period of time TBU is transmitted and stored in the deformed and processed waveform storage means 4 . On the other hand, when the digital data of the input information 400 to be transmitted is 0, the waveform of the analog signal 400 input within the 1/4 basic unit period time TBU is set not to be transmitted to the deformed and processed waveform storage means 4, and thus the deformed and processed analog waveform is output for each 1/4 basic unit period of time, as denoted by reference numeral 410 of Fig. 7.

Thereafter, appropriate thresholds +LB and -LB set in advance are compared to each deformed and processed waveform for each 1/4 basic unit period of time. For example, when the data of the deformed and processed waveform within each 1/4 basic unit period of time exceeds the threshold, digital data of 1 is assigned. Conversely, when the data of the deformed and processed waveform within each basic unit period of time does not exceed the threshold, digital data of 0 is assigned. Thus, the deformed and processed waveform can be obtained as digital data which responds to the digital data of the information to be transmitted. Further, with regard to this data, the number of pieces of digital data increases to 4 bits which is twice compared to a system of the related art within the basic unit period of time and 16 kinds of different 4-bit data can be obtained simultaneously.

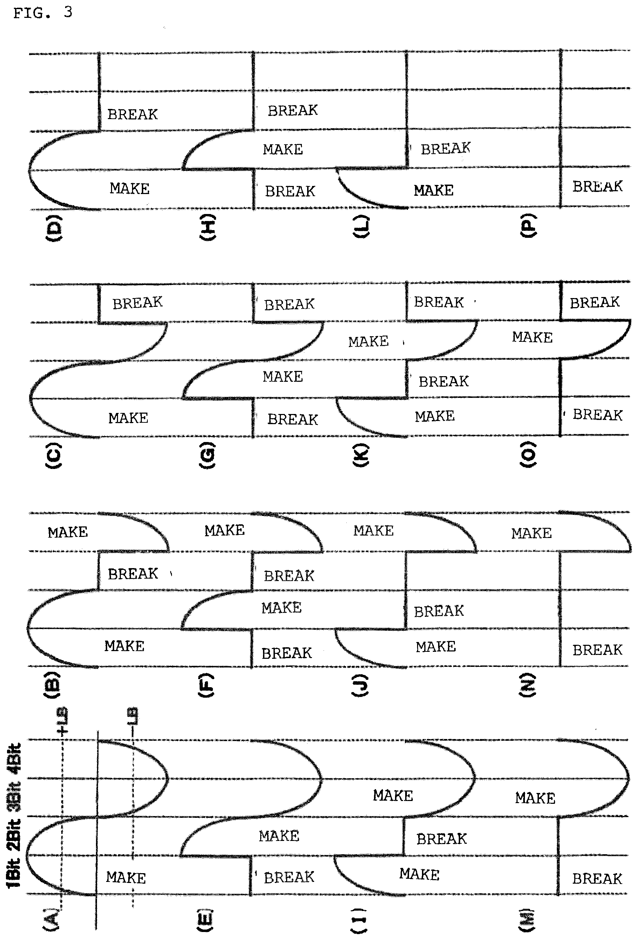

The shape of a pattern of the analog waveform 410 after the waveform deformation process which is a basis of the 16 kinds of different 4-bit data obtained in the second specific example of the present invention is exemplified in Fig. 3.

By individually comparing the pattern of the analog waveform 410 after the waveform deformation process illustrated in Fig. 3 with the appropriate thresholds +LB and -LB set in advance, 4-bit digital information with each pattern is determined.

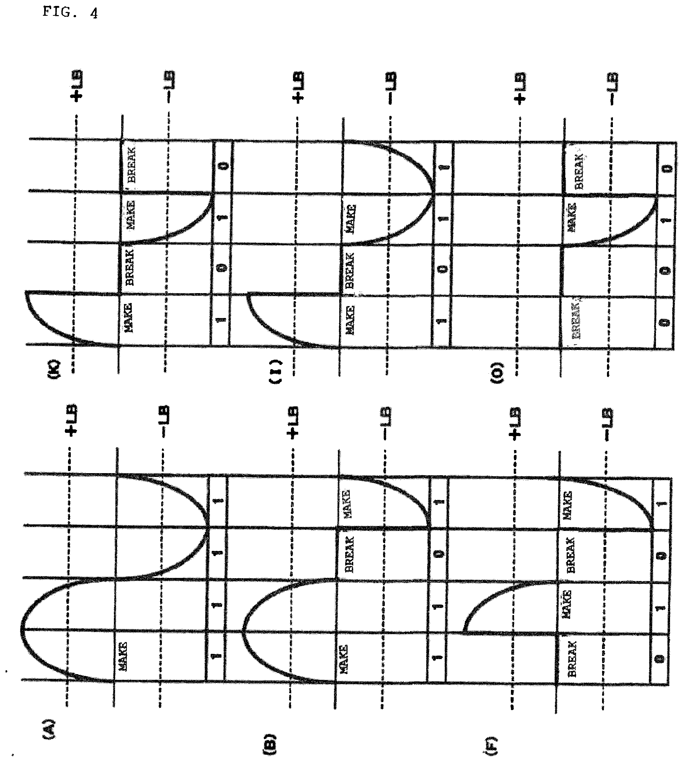

Here, an example of a method of converting the 16 pieces of analog waveform 410 after the waveform deformation process illustrated in Fig. 3 into digital data is illustrated in Fig. 4. For example, only patterns (A), (B), (F), (K), (I), and (O) in Fig. 3 will be described. The foregoing desired thresholds +LB and -LB are compared to each deformed and processed waveform at each basic unit period of time. For example, when the data of the deformed waveform within each basic unit period of time exceeds the threshold, digital data of 1 is assigned. Conversely, when the data of the deformed waveform within each basic unit period time does not exceed the threshold, digital data of 0 is assigned. Then, the deformed and processed waveform illustrated in Fig. 4(A) is specified as a 4-bit digital data group of 1111 and the deformed and processed waveform illustrated in Fig. 4(B) is specified as 4-bit digital data group of 1101. Further, the deformed and processed waveform illustrated in Fig. 4(F) is specified as a 4-bit digital data group of 0101.

Similarly, the deformed and processed waveform illustrated in Fig. 4(K) is specified as a 4-bit digital data group of 1010 and the deformed and processed waveform illustrated in Fig. 4(I) is specified as 4-bit digital data group of 1011. Further, the deformed and processed waveform illustrated in Fig. 4(O) is specified as a 4-bit digital data group of 0010.

In the desirable specific example of the present invention, an example in which the basic unit period of time is divided into 4 pieces has been described. In the present invention, the division number of the basic unit period of time is not limited to 4. The division number N may be 8 or may be 16 or 32 and further the division number can be increased to 64, 128, or the like. Ultimately, in the desired specific example of the present invention, the dividable number N of the basic unit period of time can be expressed N = 2^{x}. Here, x is one integer selected from 2 and an integer equal to or greater than 2.

In the present invention, when the division number N is set to 4, as illustrated in Fig. 4, one piece of data has a configuration of 4 bits. Then, 16 kinds of different data patterns can be obtained. When the division number N is set to 8, the number of bits of one piece of digital data is 8. Then, a set of 256 kinds of different digital data patterns can be obtained.

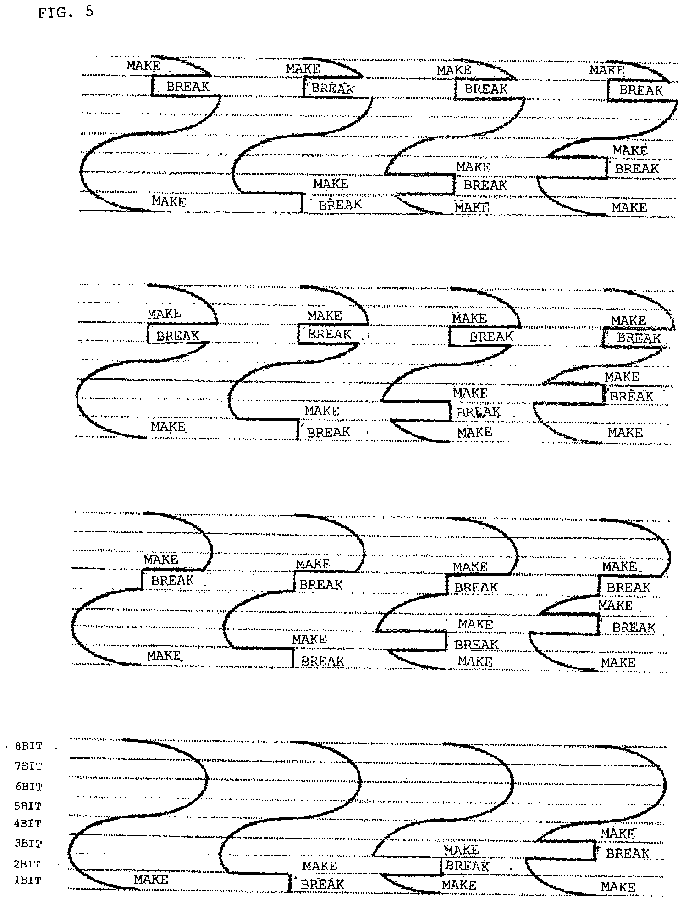

Fig. 5 exemplifies only the 16 kinds of patterns which are merely some of the set of the 256 kinds of different digital data patterns obtained when the division number N is set to 8. The principle of the digital conversion process is substantially the same as the case illustrated in Fig. 4.

Similarly, when the division number N is set to 16, the number of bits of one piece of digital data is 16, and thus a set of 65536 kinds of different digital data patterns can be obtained.

As apparent from the specific examples of the foregoing present invention, as one basic technical idea of the present invention, there is provided a high-speed tele-communication method of increasing the amount of source signal information included in the individual unit period of time, for example, 1 Hz in the carrier wave or basic frequency wave 400 in response to the division number N and further increasing the amount of source signal information included, for example, 1 Hz, within the individual unit period of time in the carrier wave or basic frequency wave 400 by 2^{x} of 2.

Here, x is one integer selected from an integer group equal to or greater than 1.

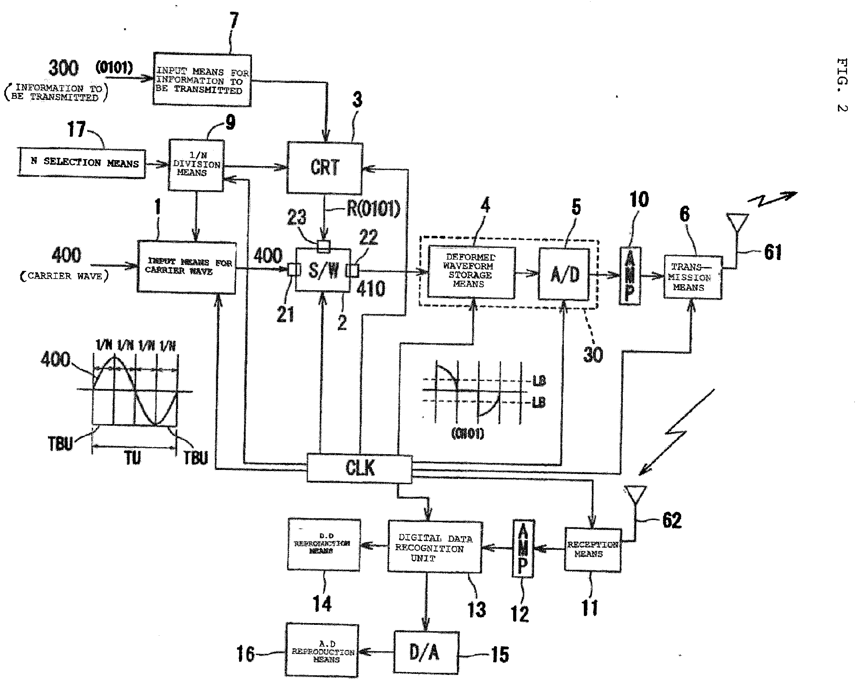

Here, to embody the foregoing second specific example, an example of a configuration of the high-speed tele-communication method 100 will be described in detail with reference to Fig. 2.

That is, as a preferable configuration example of the high-speed tele-communication method 100 according to the present invention, as a preferable specific example, the high-speed tele-communicationmethod 100 includes an input means 1 for the carrier wave or basic frequency wave 400, a signal waveform deformation processing operation means 2 for the carrier wave or basic frequency wave 400, a division number N selection means 17 for dividing one unit period time of the carrier wave or basic frequency wave 400 into N pieces, a 1/N period of time setting means 9 for setting a 1/N period of time of one unit period, that is, a time of one wavelength, in response to the selected division number N, a process operating signal generation means 3 for generating a control signal R for operating and controlling the signal waveform deformation processing operation means 2 of the carrier wave or basic frequency wave 400 in sequence for each 1/N period of time along the time axis of the carrier wave or basic frequency wave 400, an input means 7 to which digital signal 300 of the information to be transmitted is input and being connected to the processed and operated signal generation means 3 via appropriate input means 31 and further wherein, from the process operating signal generation means 3, the process control signal R corresponding to the digital data for the analog information to be transmitted which being input to the input means 7 for information to be transmitted, is out put and it is input to the switching circuit means 23 in the signal waveform deformation processing operation means 2, and thereby, said signal waveform deformation processing operation means 2 being so configured that in response to the processed and operated signal R, that is, a control signal responding to the digital signal 300 of the information to be transmitted, which is separately input thereto, either one of a process of transmitting an analog signal waveform of the carrier wave or basic frequency wave 400 within the corresponding 1/N period within one wavelength period to the output side OUT 22 (a making process), or a process of stopping the transmission of the analog signal waveform of the carrier wave or basic frequency wave 400 within the corresponding 1/N period within one wavelength period to the output side OUT 22 (a breaking process) is selectively performed, so that an output aspect is changed, and further wherein, a digitization processing means 30 is preferably provided in which by using, for example, the deformed and processed waveform storage means 4 which stores the deformed waveform therein and the analog-digital conversion means 5, both of which are connected to the output side OUT 22 of the signal waveform deformation processing operation means 2 for the carrier wave or basic frequency wave 400, the deformed and processed analog signal waveform 410 output from the signal waveform deformation processing means 2 for the carrier wave or basic frequency wave 400 is compared with a predetermined threshold LB with an appropriate level set in advance for each individual 1/N period in sequence, and when a maximum of an output value of the deformed waveform 410 within the individual 1/N period is greater than the threshold LB, the information of "1" or "0" is assigned to the deformed waveform within the 1/N period, while when a maximum of an output value of the deformed waveform 410 within the individual 1/N period is lower than the threshold LB, the information of "0" or "1" is assigned to the deformed waveform within the 1/N period and a transmission means 6 including appropriate first antenna means 61 for transmitting the digital data output from the digitization processing means 30.

The circuit configurations of the division number N selection means 17 and the 1/N period time setting means 9 used in the present invention are not particularly specified. It is possible to use known integer value selection means of the related art and a circuit device that contains timing signal generation means of transmitting a predetermined control signal which can generate a predetermined control signal by dividing a predetermined time interval TU into N pieces in response to the specified integer number N with performing synchronization with a basic clock for each 1/N time period of the predetermined time interval TU within the predetermined time interval TU.

In the present invention, instead of using the foregoing hardware, software of a program can also be used so that the foregoing timing signal is generated in response to the selected division number N.

As a desirable specific example, the digitization processing means 30 further includes appropriate storage means 4 for temporarily storing the deformed waveform 410 after the waveform deformation process output from the signal waveform deformation processing means 2, that is, deformed waveform output storage means 4 which is storage means for the deformed waveform 410 and analog-digital conversion means 5 for comparing the deformed waveform 410 stored in the deformed waveform output storage means 4 with the threshold LB.

Further, as a desirable specific example, the high-speed tele-communication method 100 according to the present invention includes an input means 7 for the information 300 to be transmitted, which is connected to the signal waveform deformation processing operation means 2. The input means 7 for the information to be transmitted is preferably connected to the process operating signal generation means 3 directly when the information 300 to be transmitted, which is input to the input means 7 for the information 300 to be transmitted includes a digital data signal, and the input means 7 is connected to the process operating signal generation means 3 via appropriate analog-digital conversion means (not illustrated) when the information to be transmitted, which is input to the input means 7 for the information 300 to be transmitted includes an analog data signal.

As a desirable specific example, in the high-speed tele-communication method 100, in short, the information 300 to be transmitted, which includes digital data corresponding to the deformed waveform is radiated and transmitted from the first antenna means 61 included in the transmission means 6 to the air via appropriate amplification circuit means 10, if desiered. Further, also as a desirable specific example, the method further includes appropriate reception means 11 including second antenna means 62 for receiving digital information corresponding to the radiated and transmitted deformed waveform, a digital data identification means 13 that is connected to the reception means 11 in short via the appropriate amplification means 12 and restores the received digital data, and data reproduction means 14 connected to the digital data identification means 13.

When analog reproduction is performed as a reproduction process in the data reproduction means 14, output data of the digital data identification means 13 can also be generated by an analog reproduction means 16 via appropriate digital-analog conversion means 15 separately provided.

As a desirable specific example, in the high-speed tele-communication method or the high-speed tele-communication system 100 according to the present invention, as in the specific example illustrated in Fig. 1, at least the input means 1 for the carrier wave or basic frequency, the analog signal waveform deformation processing operation means 2, the deformed and processed waveform storage means 4, the analog-digital conversion means 5, the operation processing signal generation means 3, the 1/N period time setting means 9, the transmission means 6, the reception means 11, the digital data identification means 13, and the like are synchronized and driven with the same reference clock means 8.w

Additionally, as a further desirable specific example, in the high-speed tele-communication method 100 or the high-speed tele-communication system according to the present invention, the switching means 23, the operation processing signal generation means 3, or the control means n3 performs a process of transmitting the analog signal waveform 400 of the carrier wave or basic frequency wave within the corresponding 1/N period to the output side OUT without change (a making process) when a digital signal of sound information and/or image information 300 to be transmitted is 1, and the switching means 23, the operation processing signal generation means 3, or the control means 3 performs a process of stopping the transmission of the analog signal waveform 400 of the carrier wave within the corresponding 1/N period to the output side OUT (a breaking process) when the digital signal 300 of the sound information and/or the image information to be transmitted is 0. Also as a further desirable specific example, in the high-speed tele-communication method 100 or the high-speed tele-communication system according to the present invention, the deformed waveform 410 output to the output side OUT through an operation of selecting the division number N is compared with the predetermined threshold LB with an appropriate level set in advance for each individual 1/N period in sequence, digital information of "1" is assigned to the 1/N period when the maximum of an output value of the deformed waveform 410 within the individual 1/N period is greater than the threshold LB, and digital information of "0" is assigned to the 1/N period when the maximum of the output value of the deformed waveform 410 within the individual 1/N period is less than the threshold LB (or vice versa).

On the other hand, as a desirable specific example, the high-speed tele-communication method or high-speed tele-communication system 100 according to the present invention includes the transmission means 6 for transmitting the digitized information to be transmitted to a spatial area via the first antenna means 61. Also as a preferable specific example, the system includes second antenna means 62 for receiving the digitized information to be transmitted, which is transmitted to the spatial area via the first antenna means 61 and reception means 14 or 16 for reproducing the received digitized information to be transmitted directly as a digital signal or converts the digitized information into an analog signal via appropriate DA conversion means 15 to reproduce the analog signal.

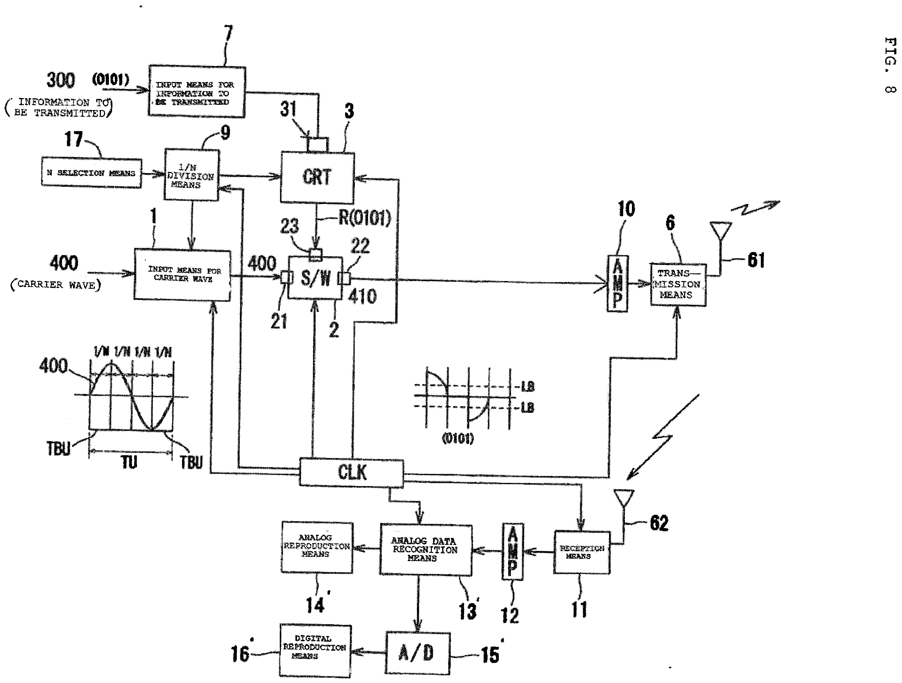

Next, a configuration of another specific example according to the present invention will be described in detail with reference to Fig. 8.

That is, in each specific example according to the foregoing present invention, as a basic technical configuration, in short, the waveform deformed by the analog signal waveform deformation processing operation means 2 is converted into the digital signal by the appropriate analog-digital conversion means 5 via the appropriate storage means 4 or the appropriate buffer means and is then transmitted through the transmission means 6, and the digitized transmission signal is received and reproduced by the digital reproduction means or reproduced in an analog form by the analog reproduction means via the appropriate digital-analog conversion means 15. However, for example, when the digital signal is transmitted, a mountain, a multistory building, or the like becomes an obstacle, and thus the digital signal interferes in the mountain, the multistory building, or the like in the transmission of the digital signal. Thus, there is a danger of not being received accurately by a partner due to deterioration in straightness.

Therefore, the inventors have examined that a transmission signal of analog data is used for transmission instead of the transmission of the transmission signal of the digital data and have consequently comprehended that the signal can be transmitted efficiently and with straightness to a predetermined reception partner without the foregoing obstacle.

Accordingly, in another specific example of the present invention, in short, the waveform deformed by the analog signal waveform deformation processing operation means 2 is transmitted as the analog signal with the deformed waveform without change from the transmission means 6 via the appropriate amplification means 10 without using the analog signal waveform deformation processing operation means 2 or the analog-digital conversion means 5.

With a change in the configuration of the transmission side, in this specific example, as illustrated, in short, the analog waveform signal received by the reception means 11 is amplified through the appropriate amplification means 12, and then the input analog waveform signal 410 is reproduced and processed through appropriate analog data reproduction means 14' via the appropriate analog data recognition means 13' without change, or the input analog waveform signal 410 is synchronized for each individual 1/N period to be compared in sequence with the predetermined threshold LB with an appropriate level set in advance, and then the analog waveform signal is converted into digitized digital data through analog-digital conversion means 15' so as to assign the information of "1" or "0" to the deformed waveform within the 1/N period when a maximum of an output value of the deformed waveform 410 within the individual 1/N period is greater than the threshold LB and to assign the information of "0" or "1" to the deformed waveform within the 1/N period when the maximum of the output value of the deformed waveform 410 within the individual 1/N period is less than the threshold LB. Thereafter, the digital data is reproduced through appropriate digital data reproduction means 16'.

## Claims

1. A high-speed tele-communication method **characterized by** deforming a waveform within a unit period of time in an analog waveform signal of a carrier wave or basic frequency wave in response to a digital signal of information to be transmitted.

2. The high-speed tele-communication method according to claim 1, wherein the waveform of the carrier wave or basic frequency wave of an output side is deformed by dividing an analog signal waveform within the unit period of time in the carrier wave or basic frequency wave into N pieces along a time axis and performing a selection operation of selecting whether to output the analog signal waveform in the carrier wave or basic frequency wave within the 1/N period to the output side or not, through appropriate switching means for each individual 1/N period in sequence, along the time axis, where N = 2^{x} and x is one integer selected from 2 and an integer equal to or greater than 2.

3. The high-speed tele-communication method according to claim 2, wherein an amount of source signal information included in the individual unit period of time in the carrier wave or basic frequency wave increases.

4. The high-speed tele-communication method according to claim 3, wherein the amount of source signal information included in the individual unit period of time in the carrier wave or basic frequency wave increases in response to the division number N.

5. The high-speed tele-communication method according to any one of claims 1 to 4, wherein the waveform deformation processing operation is performed such that the switching means performs a process of transmitting the analog signal waveform of the carrier wave or basic frequency wave within the corresponding 1/N period to the output side without change (a making process) when a digital signal of sound information and/or image information to be transmitted is 1, and the switching means performs a process of stopping the transmission of the analog signal waveform of the carrier wave or basic frequency wave within the corresponding 1/N period to the output side (a breaking process) when the digital signal of the sound information and/or the image information to be transmitted is 0.

6. The high-speed tele-communication method according to any one of claims 1 to 5, wherein the deformed analog signal waveform including the information to be transmitted is transmitted to a spatial area without change through appropriate transmission means including appropriate antenna means, or after the deformed analog signal waveform including the information to be transmitted is converted into digital data through appropriate analog-digital conversion means, the digitalized signal waveform including the information to be transmitted is transmitted to a spatial area through appropriate transmission means including appropriate antenna means.

7. The high-speed tele-communication method according to claim 6, wherein the analog-digital conversion means compares the deformed waveform which having been processed with an analog signal wave deformation processing means and being output therefrom to the output side with a threshold having an appropriate level set in advance for each individual 1/N period in sequence, and selectively assigns information of "1" or "0" to the 1/N period when a maximum of an output value of the deformed waveform within the individual 1/N period is greater than the threshold, and selectively assigns information of "0" or "1" to the 1/N period when the maximum of the output value of the deformed waveform within the individual 1/N period is less than the threshold.

8. The high-speed tele-communication method according to any one of claims 1 to 7, further comprising: with utilizing an appropriate reception means including second antenna means, receiving the analogue information to be transmitted or the digitized information to be transmitted, which is transmitted to the spatial area; and individually reproducing the received analog signal information and the received digital signal information through analog reproduction means and digital reproduction means, respectively, as it is, or after the analog signal information has been converted into the digital information via an appropriate ana log-digital conversion means or after the digital signal information has been converted into the analog information via an appropriate digital - analog conversion means, separately, individually reproducing said digital information and said analog information with utilizing the appropriate analog reproduction means and the appropriate digital reproduction means, respectively.

9. The high-speed tele-communication method according to any one of claims 1 to 8, wherein at least a carrier wave or basic frequency wave signal input means, a process operating signal generation means, a waveform deformation processing means, an output means, a transmission means and a reception means are synchronized and controlled by same reference clock means.

10. A high-speed tele-communication system comprising: at least, an input means for carrier wave or basic frequency wave, an analog signal waveform deformation processing means for the carrier wave or basic frequency wave, a process operating signal generation means for operating the analog signal waveform deformation processing means for the carrier wave or basic frequency wave, and digital signal input means for information to be transmitted, wherein the process operating signal generation means outputs an operating and processing signal in response to a digital signal of the information to be transmitted, which is input to the digital signal input means.

11. Ahigh-speed tele-communication system comprising, an input means for carrier wave or basic frequency wave, a signal waveform deformation processing means for the carrier wave or basic frequency wave, a division number N selection means for dividing one unit period of time of the carrier wave into N pieces, a 1/N period of time setting means for setting a 1/N period of time in response to the selected division number N, a process operating signal generation means for operating the signal waveform deformation processing means for the carrier wave or basic frequency wave in sequence for each 1/N period of time along a time axis of the carrier wave or basic frequency wave, and wherein said process operating signal, out put from said process operating signal generation means, is designed so that either one of a process operating signal which carries out a process of transmitting an analog signal waveform of the carrier wave or basic frequency wave within the corresponding 1/N period directly to an output side (a making process) in response to said digital signal of an information to be transmitted and a process operating signal which carries out a process of stopping the transmission of said analog signal waveform of the carrier wave or basic frequency wave within the corresponding 1/N period (a breaking process), in response to a digital signal of an information to be transmitted, is selectively output, and said high-speed tele-communication system is further comprising a first transmission means with a first antenna means for analog signal, which transmitting the deformed analog signal waveform output from the signal waveform deformation processing means for the carrier wave or basic frequency wave and being connected to an output side of the signal waveform deformation processing means for the carrier wave or basic frequency wave, without change or a second transmission means with a first antenna means for transmitting digital data output from a digitization processing means, which being provided with a digitization processing means for comparing the analog signal waveform after the deformation process with a predetermined threshold with an appropriate level set in advance for each individual 1/N period in sequence, and assigning information of "1" or "0" within the 1/N period when a maximum of an output value of the deformed waveform within the individual 1/N period is greater than the threshold, and assigning information of "0" or "1" within the 1/N period when the maximum of the output value of the deformed waveform within the individual 1/N period is less than the threshold.

12. The high-speed tele-communication system according to claim 11, further comprising, an input means for information to be transmitted, which is connected to the process operating signal generation means, wherein the input means for the information to be transmitted is connected to the process operating signal generation means directly when the information to be transmitted, which is input to the input means for the information to be transmitted, includes a digital data signal, and the input means for the information to be transmitted is connected to the process operating signal generation means via appropriate analog-digital conversion means when the information to be transmitted, which is input to the input means for the information to be transmitted, includes an analog data signal.

13. The high-speed tele-communication system according to claim 11 or 12, further comprising, a second antenna means for receiving digital data or analog data transmitted from the first antenna means, a digital data identification means or analog data identification means that is connected to the second antenna means and restores the received digital data or analog data, and a data reproduction means connected to the digital data identification means or the analog data identification means.
